Europäisches Patentamt

European Patent Office

Office européen des brevets

(19)

(11) Numéro de publication : **0 022 834**
**B1**

(12) **FASCICULE DE BREVET EUROPÉEN**

(45) Date de publication du fascicule du brevet :
**11.05.83**

(21) Numéro de dépôt : **80900240.5**

(22) Date de dépôt : **22.01.80**

(86) Numéro de dépôt international :
**PCT/FR 80/00007**

(87) Numéro de publication internationale :
**WO WO/80015 (24.07.80 Gazettee 80/17)**

(51) Int. Cl.³ : **G 01 R 15/06, H 02 H 7/04**

(54) **PERFECTIONNEMENT AUX TRANSFORMATEURS CAPACITIFS DE TENSION.**

(30) Priorité : **23.01.79 FR 7901575**

(43) Date de publication de la demande :
**28.01.81 Bulletin 81/04**

(45) Mention de la délivrance du brevet :
**11.05.83 Bulletin 83/19**

(84) Etats contractants désignés :
**CH DE GB NL SE**

(56) Documents cités :
**FR A 2 118 182**

(73) Titulaire : **ENERTEC SOCIETE ANONYME**
**12, Place des Etats Unis**
**F-92120 Montrouge (FR)**

(72) Inventeur : **LE MAGUET, Daniel**
**17 Villa Rose André**
**94310 Orly (FR)**

(74) Mandataire : **Bentz, Jean-Paul**
**GIERS SCHLUMBERGER Service BREVETS 12, place**
**des Etats-Unis**
**F-92124 Montrouge Cedex (FR)**

## Perfectionnement aux transformateurs capacitifs de tension

La présente invention est relative aux transformateurs capacitifs de tension, généralement désignés par l'abréviation TCT, et destinés à réduire une haute tension en une tension représentative plus faible, tels que définis dans le préambule de la revendication 1.

Des transformateurs de ce type sont bien connus et couramment utilisés pour la réduction de la tension de lignes à très haute tension assurant le transport de l'énergie électrique.

Traditionnellement, ces transformateurs capacitifs comprennent un réducteur constitué de deux condensateurs en série, et un transformateur à induction prélevant la tension aux bornes de l'un des condensateurs.

On connaît toutefois également, par le brevet FR 2 118 182, un transformateur capacitif de tension comprenant trois condensateurs en série, un transformateur à induction prélevant la tension aux bornes du condensateur intermédiaire, et un circuit indicateur de tension aux bornes du condensateur supplémentaire. Dans un tel transformateur, le rôle assigné au condensateur supplémentaire et au circuit indicateur est de fournir une tension image de la haute tension avec un temps de réponse aussi court que possible, c'est-à-dire reproduisant le plus fidèlement possible les variations brusques de la haute tension.

Des essais ont cependant montré que de tels transformateurs ne pouvaient pas fournir un signal de tension transitoire suffisamment fidèle dans tous les cas de figure.

Dans ce contexte, le but essentiel de la présente invention est de fournir un transformateur capacitif de tension délivrant un signal représentatif de la tension dans une ligne affectée par un défaut, susceptible de commander des protections de distance rapides avec une bonne fiabilité, et ceci même lorsque des équipements sont branchés sur le transformateur à induction inclus dans ce transformateur capacitif.

A cette fin, le transformateur capacitif de l'invention est essentiellement caractérisé comme indiqué dans la partie caractérisante de la revendication 1.

Ainsi, la relation entretenue entre la tension primaire et la tension aux bornes du circuit des troisième et quatrième impédances permet d'éviter que cette dernière tension ne soit influencée par les premiers moyens de prélèvement de tension. Le signal produit par les seconds moyens permet donc la commande de protections en fournissant constamment une image réduite fidèle de la tension primaire même lorsque l'apparition d'un défaut crée dans le circuit secondaire de la partie moyenne tension un régime transitoire d'amplitude élevée susceptible de perturber le signal de sortie de ce dernier pendant une durée non négligeable.

Une présentation plus approfondie des caractéristiques de l'invention et de leur originalité par rapport à l'art antérieur précédemment évoqué sera faite ci-après, en référence aux dessins sur lesquels :

La figure 1 est un schéma d'un transformateur capacitif de tension (TCT) conventionnel avec représentation en tirets d'une modification envisagée ;

La figure 2 est un diagramme représentant les variations de la tension d'erreur aux bornes d'un transformateur du type représenté à la figure 1 lors de l'apparition d'un défaut de la ligne où est connecté le TCT ;

La figure 3 est une coupe en élévation d'un TCT conventionnel équipé suivant l'invention ;

La figure 4 représente schématiquement le circuit du transformateur de la figure 3 ;

La figure 5 est un diagramme vectoriel illustrant les relations entre des signaux de tension complexe susceptibles d'être présents dans le circuit de la figure 4.

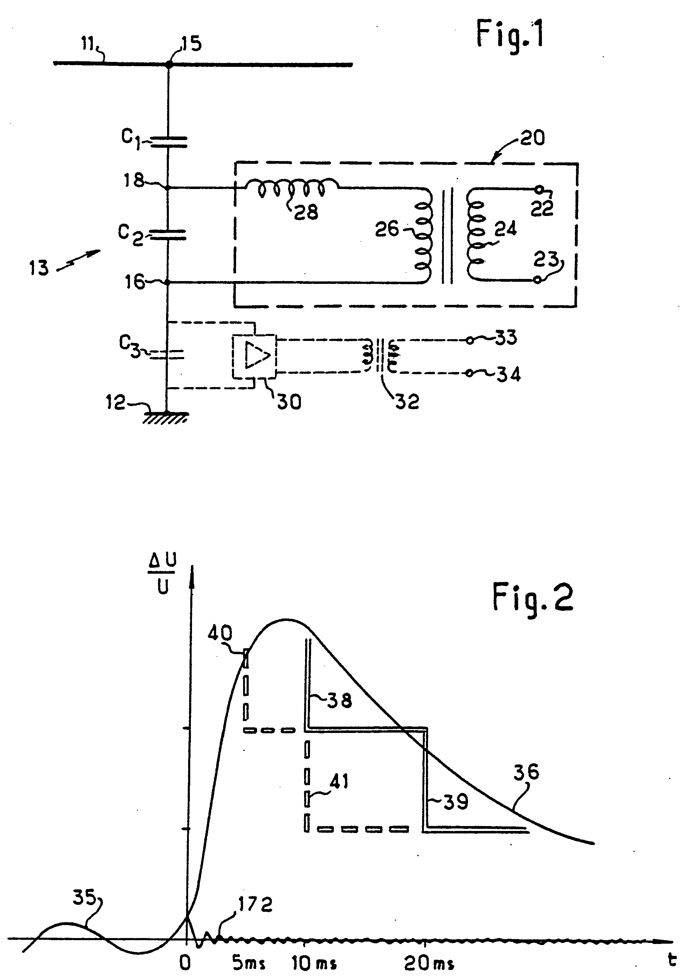

Sur la figure 1 on a représenté une ligne 11 portée à une haute tension par rapport à la terre 12 pour le transport d'énergie électrique. Un transformateur capacitif de tension (TCT) 13 conventionnel, branché entre la ligne 11 et la terre 12, comporte schématiquement deux condensateurs $C_1$ et $C_2$ branchés en série entre une borne 15 connectée à la ligne 11 et une borne 16 raccordée à la terre. Entre le point de jonction 18 des deux extrémités correspondantes des deux condensateurs $C_1$ et $C_2$ et la borne 16 est branché un circuit 20 constituant le détecteur moyenne tension du transformateur pour prélever la tension aux bornes de $C_2$. Ce circuit 20 comporte essentiellement un transformateur à induction réalisant un abaissement de tension et un isolement galvanique entre le TCT et une charge branchée aux bornes 22 et 23 de son enroulement secondaire 24, constituée par un dispositif d'exploitation du signal image de la tension de la ligne non représenté.

L'enroulement primaire 26 de ce transformateur est relié aux bornes 16 et 18 par l'intermédiaire d'une self d'accord 28.

Les transformateurs du type décrit en référence à la figure 1 sont bien connus et couramment utilisés pour la réduction de la tension de lignes à très haute tension assurant le transport de l'énergie électrique. En choisissant convenablement le rapport de transformation du circuit 20 et les valeurs des capacités des condensateurs $C_1$ et $C_2$ pour obtenir une division dans un rapport convenable de la tension existant entre la ligne 11 et la terre on peut réduire la tension primaire du TCT qui peut être par exemple de 200 KV/$\sqrt{3}$ en passant par une tension intermédiaire de 20/$\sqrt{3}$kV aux bornes de $C_2$. A titre d'exemple, la capacité du condensateur $C_1$ peut être d'environ 4 400 pF et celle du condensateur $C_2$ d'environ 44 000 pF. La tension de sortie de circuit moyenne tension 20 est en général utilisée à des fins de mesure pour alimenter des capteurs de précision 0,5 % des ré-enclencheurs, des protec-

tions d'exploitation etc.

L'intérêt des transformateurs capacitifs de tension est de permettre d'obtenir la réduction d'une tension de ligne très élevée pour un encombrement et un prix en général très inférieurs à celui des transformateurs bobinés conventionnels classiques. Ils se prêtent particulièrement bien à l'élaboration d'une tension image de la tension de ligne pour les besoins de la mesure qui ne nécessite pas la transformation de la puissance transportée par la ligne.

Parmi les applications nécessitant la mise en œuvre d'une tension réduite image de celle de la ligne 11, il en est cependant une à laquelle les TCT conventionnels se prêtent mal : il s'agit de la protection des lignes contre des défauts d'isolement dans des délais qui deviennent de plus en plus brefs. L'apparition d'un défaut dans une ligne électrique se manifeste en général par une modification soudaine d'un paramètre de fonctionnement de la ligne que l'on détecte afin de déclencher dans les meilleurs délais soit une alarme, soit un dispositif de coupure, soit des dispositifs plus complexes. Dans ces derniers la coupure de ligne est suivie d'un réenclenchement après un temps d'attente déterminé, en vue de rétablir la tension dans la ligne contenant le défaut dans l'hypothèse où le défaut s'est éliminé de lui-même, ou de la rétablir dans des lignes qui n'étaient pas directement affectées par le défaut, une fois que d'autres dispositifs de protection et de déclenchement ont isolé la ligne directement affectée par le défaut. La tendance moderne a été vers l'utilisation de systèmes de détection aux fins de protection ayant des temps de réaction de plus en plus rapides, en particulier avec l'apparition de circuits statiques pour remplacer les circuits de protection à relais électromécaniques plus traditionnels.

Il est en effet avantageux de réagir aussi vite que possible après l'apparition d'un défaut pour améliorer la protection des réseaux et accroître la rapidité de réenclenchement sur des parties du réseau qui ne sont pas directement affectées par ce défaut.

Ainsi, par exemple, si l'on considère une installation dans laquelle le temps total admissible entre l'apparition du défaut proprement dit et le déclenchement d'un disjoncteur chargé d'assurer la coupure de la ligne est de 60 millisecondes, on prévoit que l'instrument chargé de détecter la modification correspondante de la tension de ligne doit fournir une indication utile dans un temps inférieur à 10 millisecondes, la protection disposant de 20 millisecondes pour agir, ce qui laisse à un disjoncteur les 30 millisecondes restantes pour effectuer la coupure. Plus la tension nominale de la ligne est élevée, plus les temps de réaction autorisés pour la mesure de la tension de défaut et le fonctionnement de la protection sont brefs.

Lorsqu'un TCT est branché sur une ligne haute tension, tout défaut affectant cette dernière se traduit par une variation brusque de la tension aux bornes du TCT. Un cas typique est celui de la mise à la terre brutale de la ligne 11 qui se traduit par un court-circuit des bornes extrêmes du TCT. La variation brusque de la tension du primaire du TCT donne naissance à un régime transitoire au secondaire du transformateur moyenne tension de ce dernier qui peut prendre des proportions très importantes et empêche d'utiliser le signal présent aux bornes de ce secondaire pour commander les protections rapides. Ce régime transitoire est la conséquence du déséquilibre des charges existant aux bornes du branchement en parallèle des circuits selfiques 26, 28 et du condensateur $C_2$ au moment de la disparition de la tension primaire du TCT. Il introduit une erreur significative dans la reproduction de la variation de la tension pendant une durée plus longue que ne l'autorisent les normes actuelles pour l'alimentation de protections rapides.

Ainsi, l'apparition de ces protections rapides pour des réseaux à très haute tension a nécessité l'adjonction dans les postes de transformation de transformateurs de tension bobinés. Ces derniers ne présentent pas l'inconvénient mentionné ci-dessus lors des variations brusques de la tension au primaire du TCT. Mais il en résulte un accroissement sensible du coût de mise en œuvre des protections rapides. Il a donc été jugé souhaitable d'adapter les TCT pour permettre la commande de protections rapides sans avoir à faire appel à des transformateurs bobinés. A cet effet, on a proposé de brancher en série avec les condensateurs $C_1$ et $C_2$ un troisième condensateur $C_3$ entre la borne 16 et la terre 12 comme représenté en tirets sur la figure 1. Un dispositif d'amplification électronique 30 est connecté aux bornes du condensateur $C_3$ et sort sur un transformateur à induction 32 procurant l'isolement galvanique nécessaire pour un ou plusieurs dispositifs de protection aux bornes de sortie 33 et 34 de son secondaire.

Dans un tel système, un régime transitoire apparaît aux bornes de $C_3$ lors de la naissance d'un défaut affectant la ligne 11 mais son amplitude est fortement diminuée par rapport à l'amplitude du régime transitoire correspondant qui apparaît aux bornes 22 et 23 du détecteur électromagnétique. On peut démontrer en effet que toutes choses égales par ailleurs, l'amplitude relative (c'est-à-dire rapportée à la tension nominale de sortie correspondante) du régime apériodique apparaissant, lors d'un court-circuit à la terre de la borne 15 du TCT, aux bornes du condensateur $C_3$ est divisée dans le rapport $C_2/C_1$ par rapport à celle du détecteur électromagnétique 20. Dans l'exemple rapporté précédemment, elle est donc environ dix fois plus faible. Cependant, les essais ont montré que dans le cas de très hautes tensions, 220 KV et même 400 KV, ce système ne permettait pas de fournir un signal répondant aux exigences de la commande de protections statiques rapides dans tous les cas de défaut. Tel est en particulier le cas pour les court-circuits quasiment francs entre la borne 15 à la tête du TCT et la terre, le régime transitoire prenant toujours une amplitude maximale lors-

que la disparition du signal d'entrée se produit au moment de son passage à zéro.

La figure 2 représente l'évolution en fonction du temps (repéré en abcisse) d'un signal représentant en pourcentage la tension d'erreur créée par le régime transitoire. Cette tension d'erreur $\Delta U/U$ est définie conformément à la norme CEI (Comité d'Électrotechnique International) : $\Delta U$ est la tension différentielle mesurée en mettant en opposition la tension de mesure (prise aux bornes de $C_3$) avec la tension secondaire donnée par un diviseur capacitif étalon connecté à la tension primaire et ayant un rapport de tension égal au rapport de transformation nominal obtenu pour la tension aux bornes de $C_3$. U est la valeur nominale de crête de la tension secondaire (aux bornes de $C_3$) avant l'apparition du défaut. $\Delta U/U$ est porté en ordonnée.

On suppose qu'un défaut affectant la ligne 11 apparaît à l'origine des axes de coordonnées. Avant le point 0 le signal $\Delta U/U$ avait une forme sinusoïdale telle que représentée par l'onde 35. Au moment de l'apparition du défaut l'onde 35 disparaît brutalement, elle est remplacée par une onde apériodique 36 d'autant plus pointue que la tension primaire était voisine de zéro au moment du défaut et dont l'amplitude diminue graduellement jusqu'à atteindre un niveau nul. Conformément aux normes actuellement en vigueur pour une tension primaire nominale de 220 KV, il faut, pour pouvoir commander une protection rapide, que le signal 36 décroisse suffisamment rapidement pour atteindre une amplitude inférieure à 0, 30 % au bout de 10 millisecondes après l'apparition du défaut et à 0,15 % au bout de 20 millisecondes après l'apparition du défaut. Ces seuils peuvent être figurés par des fenêtres schématiquement délimitées par des traits verticaux pleins 38 et 39 sur la figure 2. Lorsque la tension nominale au primaire du transformateur est de 400 KV les seuils précédemment rapportés sont de 0,30 % après 5 millisecondes et 0,15 % après 10 millisecondes comme représenté par les fenêtres en tirets 40 et 41. Les normes requises pour produire un signal susceptible d'alimenter une protection rapide sont donc extrêmement rigoureuses et ce d'autant que ce signal doit satisfaire aux conditions mentionnées ci-dessus quelle que soit la cause qui a été à l'origine du défaut et y compris en cas de court-circuit primaire au moment du passage à zéro de la tension.

En outre, il faut garder à l'esprit que le réducteur de tension doit permettre d'obtenir le signal d'alimentation cherché même lorsque d'autres équipements sont également alimentés par ce réducteur, soit des équipements branchés sur la partie électromagnétique du TCT, soit d'autres circuits de protection rapide.

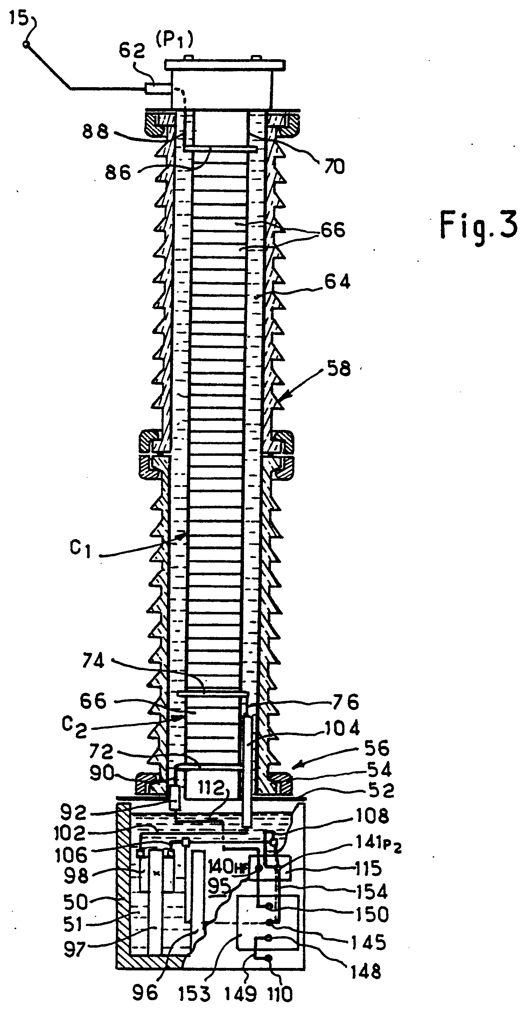

Si l'on se reporte maintenant à la figure 3, un transformateur capacitif de tension pour réseaux de 220 KV représenté comporte à sa partie inférieure une cuve 50 normalement mise à la terre et remplie d'un fluide isolant tel que de l'huile 51. La partie supérieure de la cuve 50 est fermée par un couvercle 52 sur lequel est montée une colonne creuse isolante classique à anneaux 58, dont la longueur est typiquement de l'ordre de deux mètres. La base 56 de cette colonne est fixée hermétiquement sur la partie supérieure du couvercle 52 par des pattes 54.

A la partie supérieure de la colonne apparaît une borne de connexion électrique 62 repérée par le symbole P1. L'intérieur de la colonne est rempli d'une huile isolante 64 dans laquelle se trouvent immergés deux condensateurs $C_1$ et $C_2$, formés par des empilements d'éléments capacitifs 66 montés au-dessus du couvercle 52 et qui peuvent être des condensateurs aluminium papier à imprégnation d'huile de type classique ou tout autre système capacitif convenable.

Le condensateur $C_2$ proprement dit est constitué par un premier empilement d'éléments capacitifs 66 à la base de la colonne connectés en série et formant dans le présent exemple une capacité de 44 000 pF. Il comporte une armature inférieure 72 au voisinage de la base de la colonne et une armature supérieure 74.

L'armature 74 constitue l'armature inférieure du condensateur $C_1$ lequel est constitué par un empilement d'un nombre d'éléments capacitifs 66 environ dix fois plus élevé que celui de $C_2$ pour une capacité de 4 400 pF. L'armature supérieure 86 de $C_1$ est raccordée par un conducteur 88 à la borne 62 au sommet du TCT. La borne 62 est destinée à être raccordée au point 15 à la ligne à très haute tension.

A l'intérieur de la cuve 50 du TCT est immergé dans le fluide 51 un transformateur de tension du type à induction 95. Il repose sur des supports 96 eux-mêmes solidaires du fond de la cuve. Un autre support 97 monte un boîtier contenant une self d'accord 98 branchée en série avec le primaire du transformateur 95. L'une des bornes de la self 98 est reliée par les conducteurs 102 et 76 à l'armature supérieure 74 à travers le couvercle 52 (traversée isolante 104). Une extrémité du primaire du transformateur 95 est reliée à l'autre borne d'extrémité de la self 98 par un conducteur schématiquement représenté en 106, l'autre extrémité du primaire étant reliée par un conducteur schématiquement représenté en 108 à une borne 141 (P2) faisant saillie à l'extérieur de la cuve 50. Un conducteur 90 passant par une traversée isolante verticale 92 à travers le couvercle 52 et prolongé par un câble 112 relie l'armature 72 du condensateur $C_2$ à une borne 140 (HF) faisant également saillie à l'extérieur de la cuve. Le tracé des conducteurs mentionné a été représenté schématiquement.

Une borne 110 mise à la masse de la cuve 50 fait saillie latéralement dans la paroi verticale de cette cuve à proximité d'un support isolant 115 qui reçoit deux traversées de la cuve en matériau isolant à l'intérieur desquelles sont noyés des conducteurs aboutissant aux deux bornes 140 (HF) et 141 P2. Les bornes du secondaire du transformateur ($S_1$ et $S_2$) ne sont pas visibles sur la figure 3. Un boîtier métallique 153 est fixé par des moyens non représentés sur la paroi latérale de la cuve 50. Il présente sur sa face extérieure une borne 150 reliée électriquement à la borne HF 140, une borne 145 liée à la borne 141 par un câble et une borne 148 de mise à la masse reliée par un câble 149 à la borne 110 de la cuve 50. Ces trois bornes sont connectées à deux condensateurs à l'intérieur du boîtier 153 pour la mise en œuvre de l'invention. Ce boîtier présente également une sortie non visible sur la figure pour un câble de liaison à un bâtiment de relayage.

Dans un TCT conventionnel dont les bornes 140 et 141 sont à la terre, de façon analogue au schéma en trait plein de la figure 1, la tension primaire, c.a.d. la tension existant entre la ligne à laquelle est raccordée la borne $P_1$ et la terre, est typiquement de 220 KV/$\sqrt{3}$, la tension aux bornes du condensateur $C_2$, c. à. d. entre les deux armatures 72 et 74, typiquement de 20 KV/$\sqrt{3}$ ; la tension entre les bornes $S_1$ et $S_2$ de sortie basse tension du transformateur à induction 95 est typiquement de 100 V/$\sqrt{3}$ ; c'est cette dernière tension qui est en général utilisée aux fins de surveillance de la valeur de la tension de ligne ainsi qu'en vue d'effectuer certaines fonctions de réenclenchement. Toutefois, comme il a été expliqué précédemment, il est des cas où la basse tension apparaissant entre les bornes $S_1$-$S_2$ du transformateur 95 ne fournit pas une image suffisamment fidèle de la tension de ligne lors de variations brusques de cette dernière pour permettre de commander des protections rapides en raison du régime apériodique qui prend alors naissance sous l'effet du branchement en parallèle du circuit selfique constitué par le primaire de ce transformateur avec la capacité $C_2$.

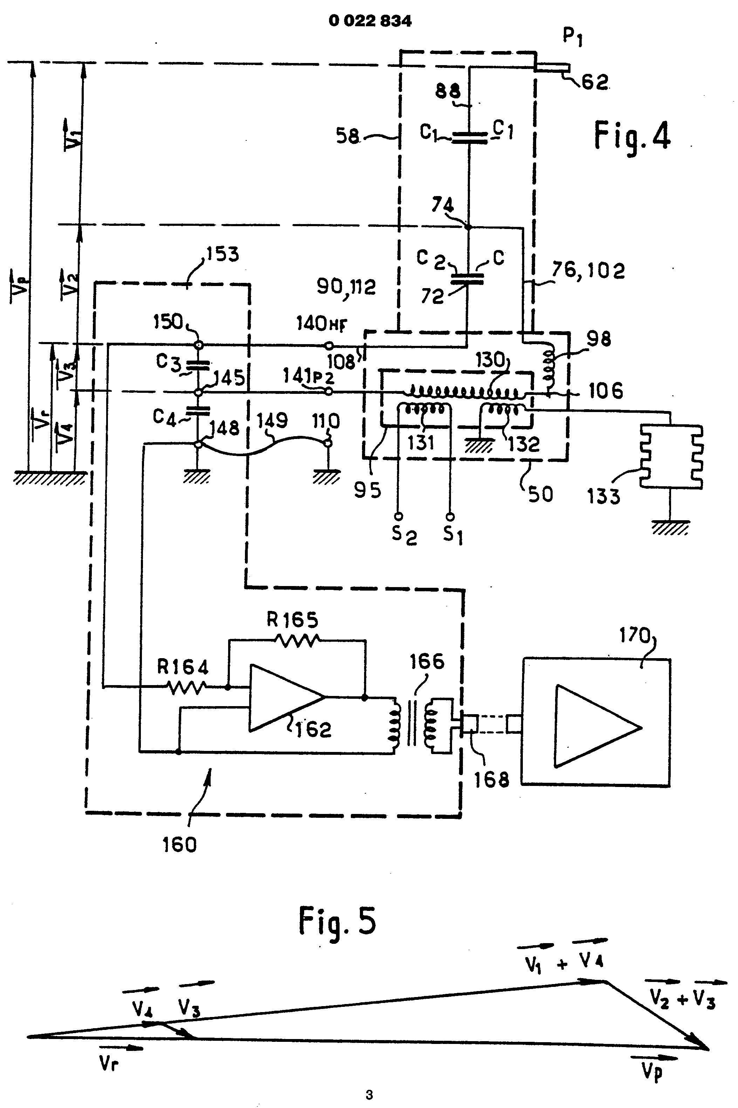

Ayant ainsi à l'esprit le contexte matériel de l'invention, on pourra se reporter pour la commodité d'explication au schéma électrique de la figure 4 sur lequel figurent les éléments qui viennent d'être décrits en référence à la figure 3. Les mêmes numéros de référence ont été utilisés tandis que les représentations symboliques des composants électriques remplacent leurs représentations géométriques ou mécaniques de la figure 3.

Très brièvement on retrouve sur la figure 4 la borne d'entrée 62 ($P_1$) au sommet du TCT, les condensateurs $C_1$ et $C_2$ en série, la self de réglage 98 en série entre l'armature 74 commune aux condensateurs $C_1$ et $C_2$ et le primaire du transformateur magnétique 95, ce dernier enroulement étant désigné par la référence 130 sur la figure 4. L'enroulement secondaire du transformateur 95 est désigné par la référence 131 avec ses sorties $S_1$ et $S_2$. Un deuxième enroulement secondaire 132 est prévu pour le transformateur 95 qui débite sur une charge d'amortissement 133 selon une technique classique.

Dans le boîtier 153 sont montés en série entre les bornes 150 et 148 deux condensateurs $C_3$ et $C_4$ dont les capacités sont sélectionnées de la manière expliquée plus avant. Le point de jonction des armatures conjointes de ces deux condensateurs est connecté à la borne externe 145, déjà citée, elle-même reliée par la borne 141 ($P_2$) à l'enroulement primaire 130 du transformateur électromagnétique 95.

L'autre armature de $C_3$ est reliée par l'intermédiaire des bornes 150 et 140 (HF) à l'armature 72 du condensateur $C_2$. L'autre armature de $C_4$ est connectée à la borne 148 du boîtier qui est représentée raccordée à la borne de mise à la masse 110.

Toutefois, il est prévu de pouvoir brancher un système d'injection ou de réception de signal haute fréquence HF entre les bornes 110 et 148 pour permettre la transmission d'informations sur les lignes de transport selon une technique classique avec le TCT. Dans un transformateur TCT conventionnel un tel circuit d'injection ou de réception vient normalement se brancher entre les bornes 110 et 140, la borne 141 étant mise à la masse.

La capacité totale du TCT qui, on l'a vu, est d'environ 4 000 pF, est déterminée en fonction des conditions de transmission d'informations à haute fréquence (HF) le long des lignes de transport d'énergie. Ces informations sont injectées ou captées au niveau du transformateur à l'aide d'un circuit résonnant dont le TCT forme l'élément capacitif et qui est complété par une self branchée en série à la tête du transformateur et non représentée.

Les condensateurs $C_3$ et $C_4$ forment un circuit série à jonction commune 145, les bornes 150 et 148 permettant le prélèvement de la tension aux bornes de ce circuit série par un détecteur de tension 160. Ce dernier est logé dans le boîtier 153 et est essentiellement composé d'un préamplificateur électronique 162, R 164 et R 165 qui adapte la tension (typiquement 100/$\sqrt{3}$ volts) aux bornes 150-148 à un niveau par exemple de 5 volts transmis au primaire d'un transformateur d'isolation 166 dont le secondaire est relié par câble 168 à un bâtiment de relayage où un amplificateur 170 traite le signal pour la commande des protections.

Le condensateur $C_3$ est en série avec $C_2$, le transformateur à induction 95 étant branché aux bornes du circuit série $C_2$, $C_3$. Le condensateur $C_4$ est branché entre le condensateur $C_3$ et la terre (à travers éventuellement un circuit d'injection ou de détection haute fréquence comme il a été dit).

Pour comprendre le fonctionnement du circuit de la figure 4, on voit donc que quatre condensateurs $C_1$, $C_2$, $C_3$, $C_4$ sont branchés en série entre la borne primaire 62 (P1) du transformateur et la terre (borne de masse 110).

La tension aux bornes de $C_2$ et $C_3$ est prélevée entre les jonctions 74 et 145 par le transformateur à induction 95, ou détecteur moyenne tension, qui délivre un signal correspondant aux bornes $S_1$ et $S_2$ de son secondaire. La tension aux bornes de $C_3$ et $C_4$ est prélevée entre les jonctions 148 et 150 par le détecteur électronique 160. $C_2$ et $C_3$ sont traversés par un même courant et en régime sinusoïdal les tensions respectives à leurs bornes respectives sont colinéaires.

$C_1$ et $C_4$ sont également traversés par un même courant et, l'impédance d'entrée du détecteur 160 étant élevée, ce courant est pratiquement égal au courant total entre la borne P1 et la terre. En régime sinusoïdal les tensions respectives à leurs bornes sont colinéaires. En se référant au schéma d'un TCT conventionnel l'association de $C_1$ et $C_4$ correspond donc fonctionnellement au condensateur $C_1$ de la figure 1. Conformément à un aspect de l'invention, il est possible en choisissant les valeurs de $C_3$ et $C_4$ convenablement par rapport à celles de $C_2$ et $C_1$ respectivement de rendre la tension prélevée par le détecteur électronique 160 pratiquement indépendante de l'existence du détecteur électromagnétique 95 quelque soit le régime sans modifier cependant le rapport de transformation de ce dernier.

Les capacités des condensateurs $C_3$ et $C_4$ sont choisies de telle manière que leur rapport soit égal au rapport des capacités des condensateurs $C_2$ et $C_1$ respectivement.

$$C_1/C_2 = C_4/C_3 \qquad (I)$$

autrement dit

$$C_4/C_1 = C_3/C_2 = \alpha \qquad (II)$$

$\alpha$ étant un coefficient qui peut être de l'ordre de 2 000 par exemple. Si l'on considère les valeurs instantanées des différences de potentiel, $V_1$, $V_2$, $V_3$, $V_4$ existant aux bornes des capacités $C_1$, $C_2$, $C_3$ et $C_4$ respectivement et la différence de potentiel $V_P$ entre la borne primaire 62 et la terre on peut écrire :

$$V_P = V_1 + V_2 + V_3 + V_4 \qquad (III)$$

et tenant compte de la relation (II)

$$V_3 = 1/\alpha V_2 \qquad (IV)$$
$$V_4 = 1/\alpha V_1 \qquad (V)$$

d'où, en combinant (IV) et (V) avec (III)

$$V_3 + V_4 = V_P/1 + \alpha \qquad (VI)$$

La différence de potentiel aux bornes du circuit série formé par le branchement des condensateurs $C_3$ et $C_4$ est donc à chaque instant représentative en valeur algébrique de la tension primaire, indépendamment du régime permanent ou apériodique de celle-ci. En particulier, si $V_P$ s'annule brusquement par suite d'un court-circuit franc sur la ligne à laquelle est connecté le primaire du transformateur TCT, la tension entre les bornes 150 et 148 s'annule également sans être affectée par le régime transitoire qui s'établit aux bornes de chacun des condensateurs $C_1$ à $C_4$ pris individuellement en raison du circuit formé par la self 98 et le transformateur 95.

Cependant, la relation existant entre la tension $V_3 + V_4$ qui apparaît entre les bornes 150 et 148 et la tension primaire reste vraie même en l'absence de court-circuit. Pour aider à bien saisir le fonctionnement de l'invention on peut se reporter par exemple au cas du régime permanent de la tension primaire. Dans ce cas on peut considérer les vecteurs de tension $\vec{V_1}$, $\vec{V_2}$, $\vec{V_3}$, $\vec{V_4}$ correspondant aux tensions aux bornes des condensateurs $C_1$, $C_2$, $C_3$, $C_4$ respectivement. La somme vectorielle de ces quatre tensions est égale à la tension $\vec{V_P}$ ou tension du primaire du TCT.

Sur la figure 5 on voit que les vecteurs $\vec{V_4}$ et $\vec{V_3}$ ont une résultante $\vec{V_r}$ qui est la tension présente entre les bornes 150 et 148. La tension totale primaire entre $P_1$ et la terre $\vec{V_P}$ est elle-même la somme vectorielle des tensions colinéaires $\vec{V_1} + \vec{V_4}$ d'une part et des tensions colinéaires $\vec{V_2} + \vec{V_3}$ d'autre part. En pratique, $\vec{V_3}$ et $\vec{V_4}$ ont été représentés sur la figure beaucoup plus grands qu'ils ne le sont en réalité et on peut considérer que $\vec{V_P}$ est la résultante vectorielle de $\vec{V_1} + \vec{V_2}$. Grâce à la relation de proportionalité existant entre les amplitudes de $\vec{V_1}$ et $\vec{V_4}$ et de $\vec{V_2}$ et $\vec{V_3}$, $\vec{V_r}$ est aligné avec $\vec{V_P}$ et fournit une image de la tension primaire constamment en phase avec elle en régime permanent.

Cette image amplifiée par le détecteur 160 peut donc être utilisée à d'autres fins que l'alimentation de protections rapides. Un intérêt majeur de ce signal image reste cependant qu'il reflète instantanément et fidèlement les variations de la tension primaire.

Dans tous les cas la relation (VI) n'est rigoureusement valable que si les relations (IV) et (V) restent exactes, ce qui implique que l'impédance d'entrée du détecteur de tension 160 soit élevée.

Cette condition est bien réalisée avec un préamplificateur électronique.

On remarquera enfin que dans le cas où des condensateurs tels que $C_3$ et $C_4$ sont utilisés, la fidélité de l'image de tension aux bornes de $C_3$, $C_4$ n'est pas affectée par les variations de fréquence du réseau dans lequel est connecté le TCT, ni par les charges appliquées en sortie à son détecteur électromagnétique.

En ce qui concerne le dimensionnement des condensateurs $C_3$ et $C_4$, les valeurs sélectionnées dans l'exemple décrit sont sensiblement les suivantes :

$$C_3 = 100 \ \mu F$$
$$C_4 = 10 \ \mu F$$

Ces valeurs sont dictées par l'équation (VI) qui fixe la valeur de $\alpha$ lorsqu'on a déterminé que la tension d'entrée du détecteur d'entrée est voisine de 100 V/$\sqrt{3}$.

Il faut noter que cette disposition peut être adoptée sans modifier le rapport de transformation du transformateur et en particulier de sa partie électromagnétique. Dans un TCT conventionnel représenté à la figure 1, ce rapport est fonction du rapport des capacités $C_1/C_2$ du diviseur capacitif. Dans le circuit de la figure 4, la valeur de ce rapport $C_1 + C_4/C_2 + C_3$ n'est pas modifiée. Il faut noter que tel ne serait pas le cas pour la modification représentée en tirets sur la figure 1.

Dans le cas d'une application de l'invention à un TCT pour réseau de 400 KV dont les condensateurs $C_1$ et $C_2$ ont pour capacités respectives :

$$C_1 = 4\ 250\ pF$$
$$C_2 = 80\ 000\ pF$$

les valeurs de $C_3$ et $C_4$ sont les suivantes :

$$C_3 = 200\ \mu F$$
$$C_4 = 10\ \mu F$$

Sur la figure 2, on a représenté les résultats d'essais effectués en mettant en œuvre l'invention pour des valeurs de capacités $C_1$ à $C_4$ correspondant à un TCT de 220 KV. Le signal d'erreur relative $\Delta U/U$ est représenté comme précédemment en 35 avant le défaut. Après le court-circuit du primaire au point 0 d'origine des temps le signal d'erreur 172 se confond avec le bruit résiduel et passe très largement à travers les fenêtres 38 et 39 imposées par les normes pour l'utilisation avec des protections rapides.

Le système selon l'invention peut être avantageusement utilisé pour équiper des TCT déjà existants sur des systèmes de réseaux de transport d'énergie qui doivent être équipés de protections statiques rapides. Ceci résulte clairement de la figure 3 qui illustre comment un dispositif conventionnel peut être équipé selon l'invention. Sur un tel TCT qui comporte normalement les bornes 140 (HF) et 141 ($P_2$) on a fixé à la cuve 50 le boîtier blindé 153 formant une enceinte blindée dans laquelle sont montés les deux condensateurs $C_3$ et $C_4$, qui peuvent être de même technologie que $C_1$ et $C_2$, et le détecteur 160. La possibilité d'adaptation qui vient d'être décrite est particulièrement avantageuse pour l'équipement à moindre coût avec des protections rapides de réseaux déjà équipés de transformateurs de mesure du type capacitif.

Cependant, des TCT mettant en œuvre l'invention peuvent être construits directement pour des installations neuves. Ils peuvent alors permettre d'allier les avantages d'une détection électromagnétique à partir de la moyenne tension régnant aux bornes du condensateur $C_2$ pour certaines applications de mesure qui nécessitent une certaine puissance de mesure avec la possibilité de détecter rapidement l'apparition d'un défaut affectant la ligne à laquelle est branché le TCT pour l'alimentation de protections rapides ainsi qu'il a été dit.

Le mode de réalisation qui vient d'être décrit permet d'obtenir une image représentative de la tension aux bornes d'un TCT qui soit insensible aux régimes transitoires de son secondaire électromagnétique de façon particulièrement simple et adaptable à des installations existantes.

On voit donc qu'en général une impédance Z3 peut être montée en série avec $C_2$ et en parallèle avec le détecteur électromagnétique moyenne tension, tandis qu'une autre impédance Z4 forme avec Z3 un circuit série et est branchée en série avec le détecteur électromagnétique et les condensateurs $C_1$ et $C_2$. Il est alors possible de déterminer les valeurs Z3 et Z4 et le branchement aux bornes du circuit série Z3 Z4 d'un circuit de détection approprié de façon telle que la sortie de ce circuit soit une fraction à tout instant de la tension primaire du TCT quel que soit le régime sur la ligne surveillée.

D'une façon générale, la tension recueillie aux bornes de deux impédances telles que Z3, Z4 est susceptible de suivre les variations de la tension primaire du TCT de façon indépendante des caractéristiques de la partie électromagnétique de celui-ci, à condition que le rapport de division de tension formé par $C_2$ et Z3 soit le même que le rapport de division formé par $C_1$ et Z4. Dans ces conditions, la fonction de transfert définie par le rapport de la tension aux bornes du circuit série Z3, Z4 à la tension primaire est indépendant de la partie électromagnétique du TCT. Il est donc possible de dériver du signal prélevé aux bornes de Z3, Z4 un signal constamment représentatif des variations de la tension primaire quel que soit le régime de cette dernière.

Il est à noter également que le système décrit pour la mesure de la tension primaire permet de s'affranchir des régimes transitoires qui pourraient prendre naissance par l'effet de tout autre quadripôle que le détecteur électromagnétique envisagé jusqu'à présent, ce quadripôle étant branché aux bornes du circuit série $C_2$ Z3 et débitant sur une charge qui est susceptible de varier.

### Revendications

1. Transformateur capacitif de tension pour la réduction d'une haute tension en une tension représentative plus faible comportant : une borne d'entrée (62) destinée à être raccordée à une ligne sous tension ; une première, une deuxième et une troisième impédances montées en série et formées respectivement par un premier ($C_1$), un deuxième ($C_2$), et un troisième ($C_3$) condensateur, montées en série et situées entre ladite borne d'entrée et un point (148) d'un milieu de référence porté, en fonctionnement, à un potentiel de référence (110) ; des premiers moyens (95, 98) de prélèvement de tension, et des seconds moyens (160) de prélèvement de tension, caractérisés en ce qu'ils comportent une quatrième impédance formée par un quatrième condensateur ($C_4$), celui-ci étant branché en série par rapport aux autres et situé entre ladite troisième impédance et le point (148) d'un milieu de référence, en ce que les premiers moyens (95, 98) sont branchés en parallèle par rapport à l'ensemble des seconde et troisième impédances pour prélever la tension aux bornes de l'ensemble des seconde et troisième impédances ($C_2$, $C_3$) ; en ce que les seconds moyens (160) sont branchés en parallèle par rapport à l'ensemble des troisième et quatrième impédances pour produire un signal fonction de la tension aux bornes de l'ensemble des troisième et quatrième impédances ($C_3$, $C_4$) ; et en ce que le rapport de division de tension formé par les première et quatrième impédances $(C_1, C_4)$ est égal à celui du diviseur de tension formé par les seconde et troisième impédances $(C_2, C_3)$.

2. Transformateur selon la revendication 1, caractérisé en ce que les seconds moyens (160) comprennent un circuit d'amplification électronique (162).

3. Transformateur selon la revendication 2, caractérisé en ce que les valeurs des capacités des troisième et quatrième condensateur $(C_3, C_4)$ sont d'un ordre de grandeur environ mille fois supérieur à celui des capacités des deuxième et premier condensateurs $(C_2, C_1)$ respectivement.

4. Transformateur selon la revendication 1, caractérisé en ce que le premier condensateur $(C_1)$ est monté sur une colonne (58) destinée à être implantée verticalement, ladite borne (62) étant reliée électriquement à une armature dudit condensateur à la partie supérieure de ladite colonne ; en ce que le deuxième condensateur $(C_2)$ a une capacité plus forte que celle du premier condensateur ; en ce que les premiers moyens de prélèvement de tension comprennent un transformateur à induction (95, 98) ; et en ce que les seconds moyens (160) de prélèvement de tension comprennent un amplificateur à impédance d'entrée élevée (162).

## Claims

1. A voltage capacitive transformer for the reduction of a high voltage to a lower representative voltage, including : an input terminal (62) intended to be connected to a line under voltage ; a first, a second and a third impedances connected in series and formed respectively by a first $(C_1)$, a second $(C_2)$ and a third $(C_3)$ capacitor, connected in series between the said first input terminal and a point (148) on a reference medium brought in operation to a reference voltage (110) ; first means (95, 98) for taking off the voltage, and second means (160) for taking off the voltage, characterized in that it comprises a fourth impedance formed by a fourth capacitor $(C_4)$, which is connected in series with respect to the others between the said third impedance and the point (148) on a reference medium, in that the first means (95, 98) are connected in parallel with respect to both the second and third impedances to take off the voltage at the terminals of the circuit formed by the second and third impedances $(C_2, C_3)$ ; in that the second means (160) are connected in parallel with the circuit formed by the third and fourth impedances to produce a signal which is a function of the voltage accross the terminals of the circuit formed by the third and fourth impedances $(C_3, C_4)$ ; and in that the ratio of division of voltage formed by the first and fourth impedances $(C_1, C_4)$ is equal to that of the voltage divider formed by the second and third impedances $(C_2, C_3)$.

2. A transformer as in claim 1, characterized in that the second means (160) comprise an electronic amplification circuit (162).

3. A transformer as in claim 2, characterized in that the values of the third and fourth capacitances $(C_3, C_4)$ are of an order of magnitude of about one thousand times greater than that of the second and first capacitances $(C_2, C_1)$ respectively.

4. A transformer as in claim 1, characterized in that the first capacitor $(C_1)$ is mounted on a column (58) to be installed vertically, the said terminal (62) being electrically connected to a plate of the said capacitor in the upper part of said column ; in that the second capacitor $(C_2)$ has a greater capacitance than that of the first capacitor ; in that the first means for taking-off the voltage comprise an induction transformer (95, 98) ; and in that the second means (160) for taking-off the voltage comprise an amplifier with a high input impedance (162).

## Ansprüche

1. Kapazitiver Spannungstransformator zur Herabsetzung einer Hochspannung auf eine geringere, repräsentative Spannung, enthaltend : Einen Eingangsanschluß (62) zum Anschließen an eine unter Spannung stehende Leitung ; eine erste, eine zweite und eine dritte Impedanz, die in Reihe geschaltet sind und aus einem ersten $(C_1)$, einem zweiten $(C_2)$ bzw. einem dritten $(C_3)$ Kondensator gebildet sind, welche in Reihe geschaltet und zwischen dem genannten Eingangsanschluß und einem Punkt (148) eines Bezugsmilieus angeordnet sind, welcher im Betrieb auf einem Bezugspotential (110) liegt ; eine erste Spannungsabgreifeinrichtung (95, 98) und eine zweite Spannungsabgreifeinrichtung (160), dadurch gekennzeichnet, daß er eine vierte Impedanz umfaßt, die durch einen vierten Kondensator $(C_4)$ gebildet ist, der in Reihe mit den anderen geschaltet ist und zwischen der dritten Impedanz und dem Punkt (148) eines Bezugsmilieus liegt, daß die erste Einrichtung (95, 98) parallel zu der aus der zweiten und der dritten Impedanz gebildeten Einheit geschaltet ist, um die Spannung an den Anschlüssen der aus der zweiten und der dritten Impedanz $(C_2, C_3)$ gebildeten Einheit abzugreifen ; daß die zweite Einrichtung (160) parallel zu der aus der dritten und der vierten Impedanz gebildeten Einheit geschaltet ist, um ein Signal zu erzeugen, das von der Spannung an den Anschlüssen der aus der dritten und der vierten Impedanz $(C_3, C_4)$ gebildeten Einheit abhängt ; und daß das durch die erste und die vierte Impedanz $(C_1, C_4)$ gebildete Spannungsteilerverhältnis gleich demjenigen des Spannungsteilers ist, der aus der zweiten und der dritten Impedanz $(C_2, C_3)$ gebildet ist.

2. Transformator nach Anspruch 1, dadurch gekennzeichnet, daß die zweite Einrichtung (160) eine elektronische Verstärkerschaltung (162) enthält.

3. Transformator nach Anspruch 2, dadurch gekennzeichnet, daß die Werte der Kapazitäten des dritten und des vierten Kondensators ($C_3$, $C_4$) um die Größenordnung von etwa 1.000 größer als die Werte der Kapazitäten des zweiten bzw. des ersten Kondensators ($C_2$, $C_1$) sind.

4. Transformator nach Anspruch 1, dadurch gekennzeichnet, daß der erste Kondensator ($C_1$) an einer zur senkrechten Errichtung bestimmten Säule (58) angebracht ist, wobei der genannte Anschluß (62) im oberen Teil der Säule elektrisch mit einem Belag des Kondensators verbunden ist ; daß der zweite Kondensator ($C_2$) eine höhere Kapazität als der erste Kondensator aufweist ; daß die erste Spannungsabgreifeinrichtung einen Induktionstransformator (95, 98) umfaßt ; und daß die zweite Spannungsabgreifeinrichtung (160) einen Verstärker mit hoher Eingangsimpedanz (162) umfaßt.

Fig.1

Fig.2

Fig.3

Fig. 4

Fig. 5